# EUROPEAN PATENT APPLICATION

(11) **EP 3 121 852 A1**
(43) Date of publication of application: **25.01.2017**
(21) Application number: 15198380.6
(22) Date of filing: 08.12.2015
(51) Int. Cl.: H01L 31/02

(54) **SOLAR CELL**

(30) Priority: 20.07.2015 TW 104211652 U
(71) Applicant: Gintech Energy Corporation, Jhunan Township, Miaoli County 350 (TW)
(72) Inventor: YEH, Chien-Feng, 350 Miaoli County 350 (TW); WU, Qi-Long, 350 Miaoli County (TW); LIN, Chih-Lung, 350 Miaoli County (TW); CHENG, Jen-Yin, 350 Miaoli County (TW); TSAI, Ching-Tang, 350 Miaoli County (TW); HUANG, Kuei-Wu, 350 Miaoli County (TW)
(74) Representative: Granleese, Rhian Jane

(57) **Abstract**

A solar cell includes a semiconductor wafer, plural finger electrodes, at least one bus electrode, and at least one finger loop electrode. The semiconductor wafer has a light-receiving surface. The finger electrodes are arranged along a first direction and disposed on the light-receiving surface. The bus electrode is arranged along a second direction and disposed on the light-receiving surface, and the bus electrode is connected with the finger electrodes, in which the second direction is perpendicular to the first direction. The finger loop electrode is substantially arranged along the second direction and disposed on the light-receiving surface, and the finger loop electrode is connected to at least two of the finger electrodes, in which the finger loop electrode has a shape of non-square periodic wave.

## Description

### BACKGROUND

### Field of Invention

The present invention relates to a solar cell.

### Description of Related Art

Solar cells are a kind of optoelectronic components associated with energy conversion. For example, for ordinary solar cells based on semiconductor materials, being radiated by sunlight electron-hole pairs are stimulated, external electrodes collect the charges, and thereto storing or using the electrical energy.

In the modern industry of the solar cells based on semiconductor materials, plural finger electrodes utilized for collecting the charges can be disposed on the silicon substrate with a screen by a screen-printing process. As the higher efficiency is pursued in the photovoltaic industry, preventing the finger electrodes from reducing the light-receiving area, the finger electrodes must be developed thinner and thinner.

### SUMMARY

In concert with the finger electrodes which are becoming thinner and thinner, embodiments of the present disclosure provides finger loop electrodes that offer additional electric connections for preventing the problems of open circuits or high resistance occurring due to an imperfect printing process. In the screen-printing process of the finger loop electrode, the squeegee may fall into openings of the screen, and thereto reduce the thickness of the electrodes. In this disclosure, by configuring the finger loop electrodes to be not perpendicular to the squeegee direction, the finger loop electrodes does not fall when the squeegee moves on the openings of the screen, and thereto ensuring the finger loop electrode has fine thickness.

According to one embodiment of the present invention, a solar cell includes a semiconductor wafer, plural finger electrodes, at least one bus electrode, and at least one finger loop electrode. The semiconductor wafer has a light-receiving surface. The finger electrodes are arranged along a first direction and disposed on the light-receiving surface. The bus electrode is arranged along a second direction and disposed on the light-receiving surface, and the bus electrode is connected with the finger electrodes, in which the second direction is perpendicular to the first direction. The finger loop electrode is substantially arranged along the second direction and disposed on the light-receiving surface, and the finger loop electrode is connected to at least two of the finger electrodes, in which the finger loop electrode has a shape of non-square periodic wave.

In some embodiments of the present disclosure, the finger loop electrode includes plural finger loop segments, each of the finger loop segments connects adjacent two of the finger electrodes, each of the finger loop segments has a local direction, and the local direction is not parallel to the second direction.

In some embodiments of the present disclosure, the local direction and the first direction has an angle in a range from 10 degrees to 89 degrees therebetween.

In some embodiments of the present disclosure, the finger loop segments are separated.

In some embodiments of the present disclosure, each two of the finger electrodes are spaced apart by a pitch, and the period of the finger loop electrode is an integral multiple of the pitch.

In some embodiments of the present disclosure, a peak and a trough of the non-square periodic wave of the finger loop electrode intersect with the finger electrodes respectively.

In some embodiments of the present disclosure, the finger loop electrode is serrated or wavy periodically.

In some embodiments of the present disclosure, a number of the at least one finger loop electrode is two, and the finger loop electrodes are serrated periodically and intersect with each other.

In some embodiments of the present disclosure, a width of the finger loop electrode is in a range from 0.01 millimeters to 0.03 millimeters.

In some embodiments of the present disclosure, the bus electrode, the finger loop electrode, and the finger electrodes are formed by a screen-printing process, and a squeegee direction of the screen-printing process is parallel to the first direction.

It is to be understood that both the foregoing general description and the following detailed description are by examples, and are intended to provide further explanation of the invention as claimed.

### BRIEF DESCRIPTION OF THE DRAWINGS

The invention can be more fully understood by reading the following detailed description of the embodiment, with reference made to the accompanying drawings as follows:
Fig. 1A is a top view of a solar cell according to an embodiment of the present disclosure;
Fig. 1B is an enlarged diagram of a portion B of Fig. 1A;
Fig. 1C is a schematic view of the solar cell of Fig. 1A at a screen-printing process;
Fig. 2A is an enlarged diagram of the solar cell according to another embodiment of the present disclosure;
Fig. 2B is an enlarged diagram of the solar cell according to another embodiment of the present disclosure; and
Fig. 2C is an enlarged diagram of the solar cell according to another embodiment of the present disclosure.

### DETAILED DESCRIPTION

Reference will now be made in detail to the present embodiments of the invention, examples of which are illustrated in the accompanying drawings. Wherever possible, the same reference numbers are used in the drawings and the description to refer to the same or like parts.

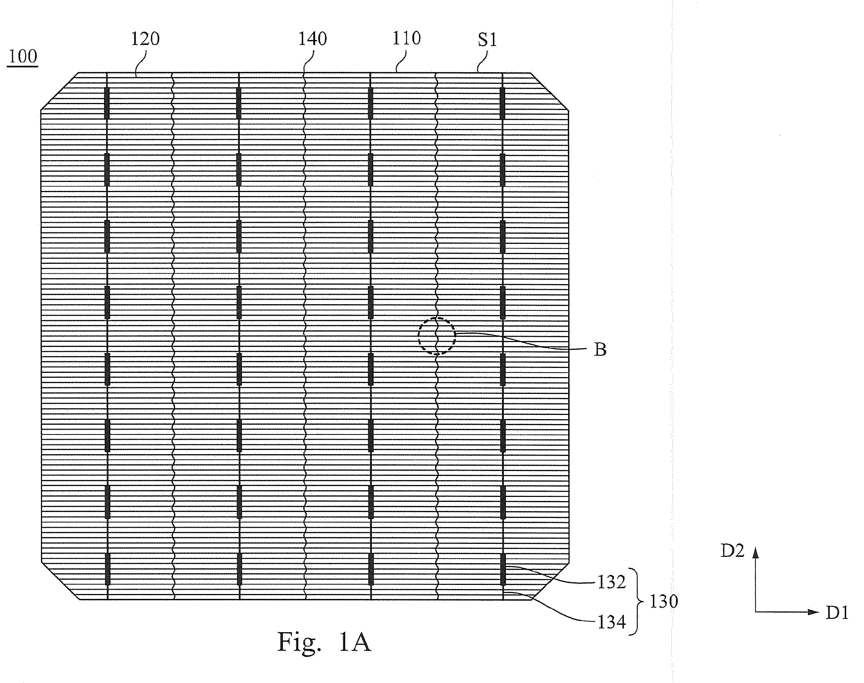

Fig. 1A is a top view of a solar cell 100 according to an embodiment of the present disclosure. The solar cell 100 includes a semiconductor wafer 110, plural finger electrodes 120, at least one bus electrode 130, and at least one finger loop electrode 140. The semiconductor wafer 110 has a light-receiving surface S1. The finger electrodes 120, the bus electrode 130, and the finger loop electrode 140 are all disposed on the light-receiving surface S1. The finger electrodes 120 are arranged along a first direction D1. The bus electrode 130 is arranged along a second direction D2, and the bus electrode 130 is connected with the finger electrodes 120, in which the second direction D2 is perpendicular to the first direction D1. The finger loop electrode 140 is substantially arranged along the second direction D2, and the finger loop electrode 140 is connected to at least two of the finger electrodes 120, in which the finger loop electrode 140 has a shape of non-square periodic wave.

The finger electrodes 120 are utilized for sending the electric charges produced in the photoelectric conversion to the bus electrode 130. The finger loop electrode 140 is utilized for offering additional path for the electric charges, in case that due to imperfect printing process, the finger electrodes 120 may have the problems of open circuit or high resistance, which may stop the transportation of the electric charges. Through the configuration of the finger loop electrode 140, the collection of the electric current may be enhanced, and thereto the efficiency of the power generation of the solar cell can also be enhanced.

In this embodiment, the bus electrode 130 includes plural wide portions 132 and plural narrow portions 134. The wide portions 132 and the narrow portions 134 are connected and interlaced, thereby saving the amount of conductive inks. In addition, the bus electrode 130 may be connected to an external electric circuit for using or storing the electric energy collected by the finger electrodes 120.

In Fig. 1A, for simplifying the drawing, the finger electrodes 120, the narrow portion 134 of the bus electrode 130, and the finger loop electrode 140 are simply depicted as lines, but in fact, the finger electrodes 120, the narrow portion 134 of the bus electrode 130, and the finger loop electrode 140 respectively have a certain width, which will be illustrated later.

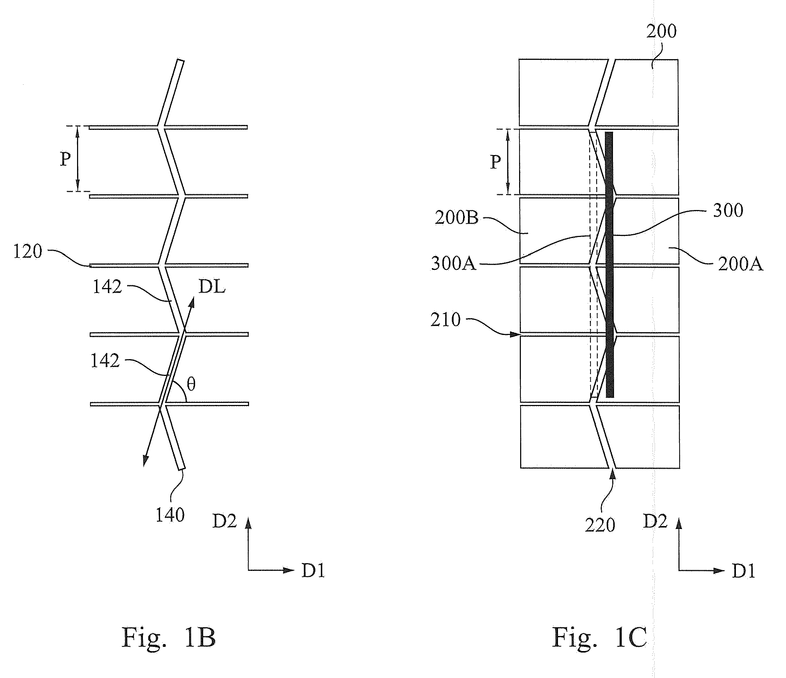

Fig. 1B is an enlarged diagram of a portion B of Fig. 1A. In one or more embodiments of the present disclosure, the finger loop electrode 140 includes plural finger loop segments 142. Each of the finger loop segments 142 connects adjacent two of the finger electrodes 120. Each of the finger loop segments 142 has a local direction DL. Herein, although the finger loop electrode 140 is substantially parallel to the second direction D2, but each of the local directions DL is not parallel to the second direction D2. In other words, on a macro scale, the finger loop electrode 140 has a main direction, which is the second direction D2, but on a micro scale, the finger loop electrode 140 may have the plural local directions DL. The above configuration benefits the screen-printing process of the finger loop electrode 140.

Fig. 1C is a schematic view of the solar cell 100 of Fig. 1A at a screen-printing process. Herein, a screen 200 and a squeegee 300 are utilized for fabricating the solar cell 100 of Fig. 1A. The screen 200 has finger openings 210 corresponding to the finger electrodes 120 of Fig. 1B and a finger loop opening 220 corresponding to the finger loop electrode 140 of Fig. 1B. For better illustration, semiconductor substrates, conductive inks, or other elements are not shown in the figure.

Reference is made to both Fig. 1B and Fig. 1C. In the screen-printing process, the screen 200 is deposed above the semiconductor substrate, conductive inks are then applied onto the screen 200, subsequently, the squeegee 300 moves on the screen 200 and scratches the inks onto the semiconductor substrates. In this embodiment, a squeegee direction of the squeegee 300 is parallel to the first direction D1. For example, the squeegee 300 moves along the first direction D1 to the position 300A. Next, after baking and drying the inks, various electrode patterns may be formed on the semiconductor substrate, such as finger loop electrode 140 and the finger electrodes 120.

In some situations, the finger loop electrode may be perpendicular with the finger electrodes, such that the finger loop opening is perpendicular with the squeegee direction of the squeegee 300. Since the squeegee 300 has a determined width and thickness, when a width of the finger loop opening is greater than the thickness of the squeegee 300, the squeegee 300 may fall into the finger loop opening in the printing process. In this way, the squeegee 300 may remove excessive ink, resulting in the finger loop electrode 140 (see Fig. 1B) having an increased thickness, and thereto the resistance may be increased.

In the present embodiment, the finger loop electrode 140 (see Fig. 1 B) is configured to be not perpendicular with the squeegee direction. That is, the finger loop electrode 140 is not parallel with the second direction D2. Therefore, the squeegee 300 may be prevented from falling into the finger loop opening 220 in the imprinting process. To be specific, two portions of the screen 200 on two opposite sides of the finger loop opening 220 can support the squeegee 300 subsequently in the imprinting process. For example, a right portion 200 A of the screen 200 on the right side of the finger loop opening 220 can support a portion of the squeegee 300 first, and then when the squeegee 300 moves from right to left (such as the position 300A), as the portion of the squeegee 300 gradually leaves the right portion 200 A, a left portion 200 B of the screen 200 gradually receives and supports another portion of the squeegee 300. Through the configuration of the finger loop opening 220, the screen 200 may support the squeegee 300 in the process of imprinting.

In Fig. 1C, the relative sizes or scales of the squeegee 300 and the finger loop opening 220 are only depicted for better illustration, and should not be used to limit the scope of the present disclosure. Though it is not shown in the figures, in actual, the thickness of the squeegee 300 may be smaller than the width of the finger loop opening 220.

Table 1 shows experimental results according to plural embodiments of the present disclosure. Reference is made to both Fig. 1B and Table 1. One of the local directions DL of the finger loop electrode 140 and the first direction has an angle *θ*. As the angle *θ* decreases, the ratios of the thicknesses and widths of the finger loop electrode 140 (which is referred to as aspect ratios) are also decreasing.

**Table 1**

| Angle, *θ* | Aspect ratio |
|---|---|
| 0 | 0.365 |
| 15 | 0.355 |
| 30 | 0.330 |
| 45 | 0.305 |
| 89 | 0.30 |
| 90 | 0.28 |

Comparing to the aspect ratio when the angle *θ* is 90 degrees, the aspect ratio when the angle *θ* is configured to be 89 degrees is greater, and that is, the finger loop electrode 140 has a greater thickness when the angle *θ* is 89 degrees. The reason is that the squeegee 300 (see Fig. 1 C) may fall into the finger loop opening 220 (see Fig. 1 C) in the imprinting process when the angle *θ* is 90 degrees. When the angle *θ* is 89 degrees, at least a portion of the screen 200 (see Fig. 1 C) may support the squeegee 300 (see Fig. 1 C). In this embodiments, for saving the amount of inks and enhancing the light-receiving area of the solar cell, the angle between one of the local directions DL and the first direction D1 is in a range from about 10 degrees to 89 degrees, such that the screen may offer better supporting effect, and thereto increasing the thickness of the finger loop electrode 140.

Reference is made to Fig. 1A and Fig. 1B. In this embodiment, through the configuration of the periodic arrangement, the range of the distribution of the finger loop electrode 140 may be narrowed for preventing the finger loop electrode 140 from overly influencing the reception of light directed towards the solar cell. To be specific, herein, it may be designed that the local direction DL of each of the finger loop segments 142 has a vector opposite to a vector of the local directions DL of the adjacent finger loop segments 142, such that projections of the plural finger loop segments 142 on the first direction D1 are overlapped. Of course, it should not limit the scope of the present disclosure, and various arrangements of non-square periodic waves may be applied in the present embodiment.

In one or more embodiments of the present disclosure, each two of the finger electrodes 120 are spaced apart by a pitch P, and the period of the finger loop electrode 140 is an integral multiple of the pitch P. In some embodiments, the period of the finger loop electrode 140 may be configured to be an even multiple of the pitch P, such as double of the pitch P shown in the present embodiment. Through the configuration, a peak and a trough of the non-square periodic wave of the finger loop electrode 140 intersect with the finger electrodes 120 respectively, in case that adhesions of the inks may lower the fineness due to the narrow distance between the finger electrodes 120 and the peak or the trough of the non-square periodic wave of the finger loop electrode 140 in the printing process.

In one or more embodiments of the present disclosure, a width of the finger loop electrode 140 has a value between the values of the width of the finger electrodes 120 and the width of the bus electrode 130. To be specific, the width of the finger loop electrode 140 may be in a range from 0.01 millimeters to 0.03 millimeters, the width of the finger electrodes 120 may be in a range from 0.01 millimeters to 0.01 millimeters, and the bus electrode 130 may be in a range from 0.2 millimeters to 2 millimeters. In one or more embodiments of the present disclosure, the number of the finger loop electrode 140 may be in a range from 1 to 10, the number of the finger electrodes 120 may be in a range from 30 to 180, and the number of the bus electrode 130 may be in a range from 2 to 15.

In this present embodiment, each of the finger loop segments 142 has a local direction DL, but it should not limit the scope of the present disclosure. In some different embodiments, it may be configured that each two (or above) of the finger loop segments 142 has a local direction DL. In fact, in an actual operation, the finger loop electrode 140 may be divided into several segments having local directions DL based on the thickness and width of the squeegee 300 (see Fig. 1 C). The description "each of the finger loop segments 142 has a local direction" should not limit the scope of the present disclosure.

Herein, the finger loop electrode 140 is periodically serrated, but it should not limit the scope of the present disclosure.

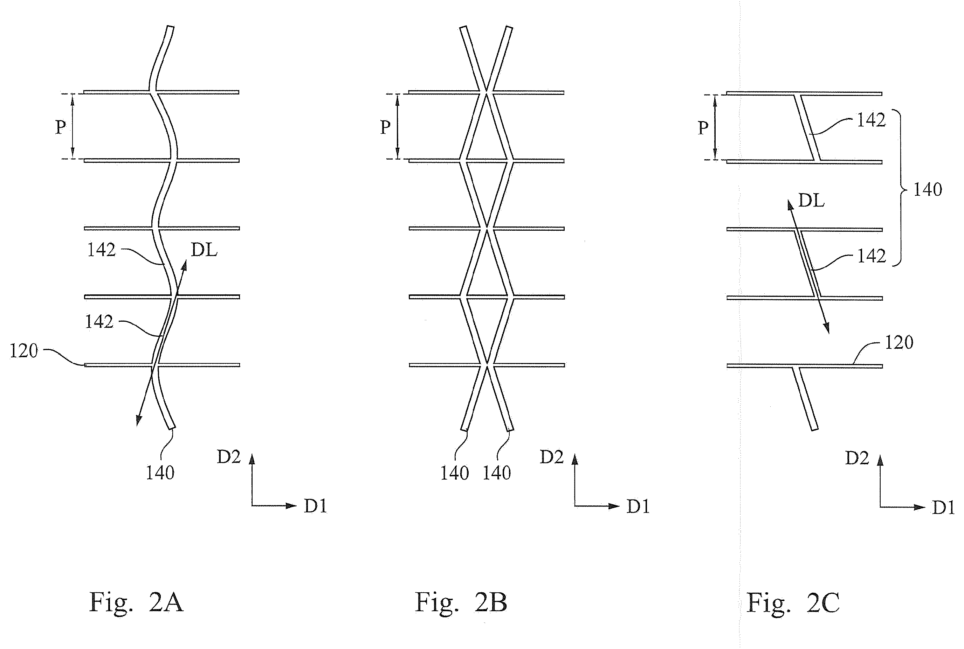

Fig. 2A is an enlarged diagram of the solar cell according to another embodiment of the present disclosure. The present embodiment is similar to the embodiment of Fig. 1B, and the difference is that: the finger loop electrode 140 is wavy in this embodiment, and the period of the finger loop electrode 140 is four times the pitch P.

As a result, similarly, through the configuration of the non-square periodic wave of the finger loop electrode 140, the problems that the squeegee may fall into the elongated opening perpendicular to the squeegee direction in the imprinting process may be overcome. And, similarly, a peak and a trough of the non-square periodic wave of the finger loop electrode 140 may be configured to intersect with the finger electrodes 120 respectively, in case that adhesions of the inks may lower the fineness due to the narrow distance between the finger electrodes 120 and the peak or the trough of the non-square periodic wave of the finger loop electrode 140 in the imprinting process.

Other details of the present embodiment are similar to the embodiment of Fig. 1B, and thereto not repeated herein.

Fig. 2B is an enlarged diagram of the solar cell according to another embodiment of the present disclosure. The present embodiment is similar to the embodiment of Fig. 1B, and the difference is that: the number of the finger loop electrodes 140 is two in this embodiment, and the finger loop electrodes 140 intersect with each other.

Herein, the finger loop electrodes 140 are respectively serrated, but it should not limit the scope of the present disclosure. The finger loop electrodes 140 may be wavy as shown in Fig. 2A, or may have a shape of other non-square periodic waves.

Similarly, in this present embodiment, through the configuration of the non-square periodic waves of the finger loop electrodes 140, the problems that the squeegee may fall into the elongated opening perpendicular to the squeegee direction in the imprinting process may be overcome.

Other details of the present embodiment are similar to the embodiment of Fig. 1B, and thereto not repeated herein.

Fig. 2C is an enlarged diagram of the solar cell according to another embodiment of the present disclosure. The present embodiment is similar to the embodiment of Fig. 2A, and the difference is that: in this embodiment, the finger loop segments 142 are separated.

Herein, since the configuration of the finger loop electrodes 140 is different from that shown in the embodiment of Fig. 1B, it is not designed in the present embodiment that that the local direction DL of each of the finger loop segments 142 has a vector opposite to a vector of the local directions DL of the adjacent finger loop segments 142, but still the projections of the plural finger loop segments 142 on the first direction D1 are overlapped.

As a result, similarly, in this embodiment, through the configuration of the non-square periodic wave of the finger loop electrode 140, the problems that the squeegee may fall into the elongated opening perpendicular to the squeegee direction in the imprinting process may be overcome. And, similarly, a peak and a trough of the non-square periodic wave of the finger loop electrode 140 may be configured to intersect with the finger electrodes 120 respectively, in case that adhesions of the ink may lower the fineness due to the narrow distance between the finger electrodes 120 and the peak or the trough of the non-square periodic wave of the finger loop electrode 140.

In addition, through the configuration of the non-square periodic wave of the finger loop electrode 140, the range of the distribution of the finger loop electrode 140 may be narrowed for preventing the finger loop electrode 140 from overly influencing the reception of light directed towards the solar cell.

Other details of the present embodiment are similar to the embodiment of Fig. 2A, and thereto not repeated herein.

In concert with the finger electrodes which are becoming thinner and thinner, embodiments of the present disclosure provides finger loop electrodes that offer additional electric connections for preventing the problems of open circuits or high resistance occurring due to an imperfect printing process. In the screen-printing process of the finger loop electrode, the squeegee may fall into openings of the screen, and thereto reduce the thickness of the electrodes. In this disclosure, by configuring the finger loop electrodes to be not perpendicular to the squeegee direction, the finger loop electrodes does not fall when the squeegee moves on the openings of the screen, and thereto ensuring the finger loop electrode has fine thickness.

## Claims

1. A solar cell (100), **characterized by** comprising:
a semiconductor substrate having a light-receiving surface (S1);
a plurality of finger electrodes (120) arranged along a first direction (D1) and disposed on the light-receiving surface (S1);
at least one bus electrode (130) arranged along a second direction (D2) and disposed on the light-receiving surface (S1), wherein the bus electrode (130) is connected with the finger electrodes (120), and the second direction (D2) is perpendicular to the first direction (D1); and
at least one finger loop electrode (140) substantially arranged along the second direction (D2) and disposed on the light-receiving surface (S1), wherein the finger loop electrode (140) is connected to at least two of the finger electrodes (120), and the finger loop electrode (140) has a shape of a non-square periodic wave.

2. The solar cell of claim 1, **characterized in that** the finger loop electrode (140) comprises a plurality of finger loop segments (142), each of the finger loop segments (142) connects adjacent two of the finger electrodes (120), each of the finger loop segments (142) has a local direction (DL), and the local direction (DL) is not parallel to the second direction (D2).

3. The solar cell of claim 2, **characterized in that** the local direction (DL) and the first direction (D1) has an angle (*θ*) in a range from 10 degrees to 89 degrees therebetween.

4. The solar cell of claim 2, **characterized in that** the finger loop segments (142) are separated.

5. The solar cell of claim 1, **characterized in that** each two of the finger electrodes (120) are spaced apart by a pitch (P), and a period of the finger loop electrode (140) is an integral multiple of the pitch (P).

6. The solar cell of claim 1, **characterized in that** a peak and a trough of the non-square periodic wave of the finger loop electrode (140) intersect with the finger electrodes (120) respectively.

7. The solar cell of claim 1, **characterized in that** the finger loop electrode (140) is serrated or wavy periodically.

8. The solar cell of claim 1, **characterized in that** a number of the at least one finger loop electrode (140) is two, and the finger loop electrodes (140) are serrated periodically and intersect with each other.

9. The solar cell of claim 1, **characterized in that** a width of the finger loop electrode (140) is in a range from 0.01 millimeters to 0.03 millimeters.

10. The solar cell of claim 1, **characterized in that** the bus electrode (130), the finger loop electrode (140), and the finger electrodes (120) are formed by a screen-printing process, and a squeegee direction of the screen-printing process is parallel to the first direction (D1).
